# EUROPEAN PATENT APPLICATION

(11) **EP 4 642 175 A1**
(43) Date of publication of application: **29.10.2025**
(21) Application number: 25170810.3
(22) Date of filing: 15.04.2025
(51) Int. Cl.: H05K 7/18

(54) **ELECTRONIC RACK AND MOUNTING CHASSIS**

(30) Priority: 24.04.2024 GB 202405762
(71) Applicant: CP Cases Ltd, TW7 6ER (GB)
(72) Inventor: Ross, Peter, Isleworth, TW7 6ER (GB)
(74) Representative: Dolleymores

(57) **Abstract**

The present disclosure relates to an electronic rack and mounting chassis comprising: a front chassis member; a rear chassis member; a plurality of elongate chassis members extending in a front-to-rear direction and connecting the front and rear chassis members, wherein each of the front and rear chassis members comprises two opposing horizontal sections, two opposing vertical side sections and four corner sections, each of the four corner sections connecting a respective one of the horizontal sections to an adjacent one of the vertical side sections to form a looped structure, wherein each of the front and rear chassis members comprises one or more folded elements being folded to define the four corner sections, and wherein each of the front and rear chassis members further comprises at least one joint at which respective ends of the one or more folded elements are connected to form the looped structure, the or each joint being formed in one of the vertical and horizontal sections so as to be remote from each corner section. The disclosure also relates to a container comprising the chassis.

## Description

The present disclosure relates to an electronic rack and mounting chassis and to a container comprising the electronic rack and mounting chassis.

Portable containers provided with electronic rack and mounting chassis for the mounting of sensitive electronic apparatus are well known; these generally comprise a rigid outer casing within which the rack and mounting chassis is mounted via anti-vibration mounts. The mounted apparatus may be safely stored and transported in the container and remains in the container during use.

The usable internal space of the container is determined by the chassis. That is, the chassis defines a storage space that can be used to store equipment. However, with the above-described arrangement, the internal volume of the container comprises an inherent 'dead space' between the internal surfaces of the container and the storage space defined by the chassis, the 'dead space' being determined, in part, by the dimensions of the components forming the chassis and the dimensions of the anti-vibration mounts. Thus, for any given storage/payload space defined by the chassis, the overall dimensions of the container must be larger to allow for the mounting of the chassis within the container.

At the same time, it is desirable that the overall dimensions of a container for any given payload capacity is minimised. Accordingly, there remains a need maximise the usable storage/payload space within the container such that the overall external dimensions of the container can be minimised for efficient storage and transport. Similarly, it is desirable that the containers, including the internal chassis, are made as lightweight as possible to meet demanding weight targets and to improve efficiency of transport.

The present invention arose in a bid to provide an improved electronic rack and mounting chassis, having minimum footprint and weight for a given storage/payload capacity.

According to a first aspect of the present invention there is provided an electronic rack and mounting chassis comprising:
a front chassis member;
a rear chassis member;
a plurality of elongate chassis members extending in a front-to-rear direction and connecting the front and rear chassis members,
wherein each of the front and rear chassis members comprises two opposing horizontal sections, two opposing vertical side sections and four corner sections, each of the four corner sections connecting a respective one of the horizontal sections to an adjacent one of the vertical side sections to form a looped structure,
wherein each of the front and rear chassis members comprises one or more folded elements, each folded element comprising a hollow tubular member having a substantially square or rectangular cross-sectional profile, folded to form one or more of the corner sections, with each corner section comprising a curved outer face and opposing wing portions positioned on either side of the curved outer face, the wing portions extending outwardly beyond the curved outer face, and
wherein each of the front and rear chassis members further comprises at least one joint at which respective ends of the one or more folded elements are connected to form the looped structure, the or each joint being formed in one of the vertical and horizontal sections so as to be remote from each corner section.

The use of hollow extruded sections having a substantially square or rectangular cross-sectional profile for the chassis members provides significant rigidity to the chassis and, with the above arrangement, each of the front and rear chassis members defines an opening into which electronic equipment (or any other desired equipment or other items) can be inserted for mounting within the chassis. By forming the front and rear chassis members in a looped structure (i.e. as a ring having a square or rectangular profile) with folded corner sections, the overall dimensions of the chassis for a given payload capacity can be minimised. Additionally, the strength and rigidity at the corners is significantly increased, compared to an arrangement at which vertical and horizontal members are connected/joined at the corner sections, either directly or indirectly.

The unique arrangement of the present invention has also been found to provide a strong, stable support for mounted equipment, with significantly reduced weight compared to other chassis arrangements known in the prior art. The present invention therefore provides a chassis, and container comprising a chassis, having a very high strength to weight ratio.

Thus, the overall arrangement provides a chassis, and a container comprising a chassis, having sufficient strength and rigidity to securely store and transport equipment (in particular electronic equipment) mounted within the chassis, whilst the overall footprint and weight of the chassis is minimised.

Preferably, at least one of the front chassis member and the rear chassis member comprises a single, unitarily formed folded element that is folded so as to define the two horizontal sections, two vertical side sections and four corner sections, wherein a single joint connects a first end of the folded element to a second end of the folded element to form the looped structure, said joint being formed in one of the vertical and horizontal sections so as to be remote from each corner section. Accordingly, the front and/or rear chassis members are not formed of a plurality of interconnecting components and the number of joints required in the chassis is reduced to a minimum. With only a single joint located away from the corner sections of the front/rear chassis members, the strength of the chassis is improved.

Preferably, each corner section of the or each folded element comprises an recess formed in a wall of the hollow member that forms an internal part of the corner section. This relieves stress at the folded corner section, thus allowing a very tight fold to be formed, thus minimising the overall dimensions of the chassis for a given storage/payload capacity.

Preferably, each corner section comprises an inner face and wherein the opposing wing portions extending outwardly beyond the curved outer face have a rediused outer profile and wherein each wing portion defines a side edge of the inner face and wherein each side edge of the inner face of each corner section is substantially right angled. The wing portions enhance the rigidity of the folded elements at the corner sections, by extending the side wall portions of the tubular member around the region of the fold, thus enhancing the rigidity of the chassis.

The or each folded element may be crush folded.

Preferably, each elongate chassis member is connected to the front chassis member and the rear chassis member at a position remote from each corner section of the front and rear chassis members.

Preferably, each of the front chassis member and the rear chassis member comprises an outwardly-facing wall extending around an outer periphery of the front or rear chassis member, an inwardly-facing wall extending around an inner periphery of the front or rear chassis member, and two opposing side walls extending between the outwardly-facing wall and the inwardly-facing wall.

Preferably, each elongate chassis member is connected to each of the front and rear chassis members without extending beyond the outwardly-facing wall thereof. This allows the outwardly-facing walls of the front and rear chassis members to be positioned as close as possible to the internal walls of a container in which the chassis is mounted, thus minimising the dimensions of the container whilst maximising the internal usable volume of the container that is defined by the chassis.

Each elongate chassis member may engage with the inwardly-facing wall and/or at least one of the side walls of each of the front and rear chassis members. Rigidity of the connection between the elongate chassis members and the front/rear chassis members is thereby increased.

Each of the front and rear chassis members may comprise a hollow member, as described above, and each elongate chassis member comprises a tab arranged to be received within an aperture formed in one of the side walls of one of the front or rear chassis members, said tab extending into an internal cavity of the hollow member and engaging with an internal surface of the hollow member. This allows the tab to be engaged with a wall of the front/rear chassis member, without extending beyond/protruding from an external surface of the front/rear chassis member. The outer dimensions of the front/rear chassis members are thereby minimised, allowing the chassis to be brought into close proximity with a wall of a container in which the chassis is mounted.

Each elongate chassis may comprise a tab that engages with an external surface of the inwardly-facing wall of each of the front or rear chassis members.

The joint may comprise a bracket bridging between the respective ends of the one or more folded elements so as to connect said ends together to form the joint, the bracket being arranged so as not to extend beyond the outwardly-facing wall of the front or rear chassis member. The outer dimensions of the front/rear chassis members are thereby minimised, allowing the chassis to be brought into close proximity with a wall of a container in which the chassis is mounted.

The bracket may engage with the inwardly-facing wall and/or at least one of the side walls of the front or rear chassis member. The bracket may be U-shaped and may engage the two side walls and the inwardly-facing wall of the front or rear chassis member. A strong joint can thereby be formed.

The joint may alternatively be formed by other arrangements. For example, where the folded element or elements to be joined comprise hollow members, the joint may be formed by a double-ended plug arranged to be tightly accommodated within the hollow sections of the two respective ends to be joined. After installation, the plug may be permanently secured in place within the two joined ends, for example by bonding or welding.

Preferably, a vertical side section of at least one of the front and/or rear chassis members comprises a substantially planar front face having an aperture formed therein, and a fastener for the fastening of equipment to the chassis, wherein the fastener comprises a nut having a head portion having a dimension that is greater than a diameter of the aperture, the head portion being arranged to engage with the substantially planar front face, the nut further comprising a neck portion having a diameter smaller than the diameter of the aperture, and a locking portion having a dimension that is greater than a diameter of the aperture and being arranged to engage with a face of the vertical side section opposing the substantially planar front face. This arrangement allows the head portion to be formed with a very low profile (that is, a small thickness in a direction perpendicular to the planar front face), allowing mounted equipment to sit substantially flat against the planar front face of the vertical section.

Preferably the aperture is formed in a wall of a hollow member forming the vertical side section, said wall having an external face defining the substantially planar front face of the vertical side section, and an opposing internal face with which the locking portion of the nut engages.

Preferably, each vertical side section of the front and/or rear chassis members comprises a plurality of apertures and fasteners as described above for the fastening of equipment to the chassis.

According to a second aspect of the present invention, there is provided a container comprising an electronic rack and mounting chassis in accordance with the above aspect of the present invention.

The container may comprise a body which comprises a box with four walls, which extend in the front to back direction, the box comprising an opening at one or both of its ends, wherein the or each open end is closed using a removable lid, and anti-vibration mounts are provided for mounting the electronic rack and mounting chassis within the container.

According to a third aspect of the present invention there is provided a method of forming a folded element of an electronic rack and mounting chassis in accordance with the first aspect of the present invention, the method comprising: taking a straight hollow tubular member having a substantially square or rectangular cross-sectional profile having a width and a height; placing the tubular member between two parts of a tool of a press and closing the press to fold the tubular member to form one of the corner sections, the action of closing the press forming the corner section, including forming the curved outer face of the corner section and the opposing wing portions positioned on either side of the curved outer face, which wing portions extend outwardly beyond the curved outer face, wherein the tool comprises: a female part in the form of a block substantially equal in width to the width of the tubular member and having a V - shaped notch facing in a first direction into a mouth of the press, with inner faces of the V - shaped notch being at right angles to each other; a male part, opposed to the female part, the male part in the form of a V - shaped wedge substantially equal in width to the width of the tubular member with the outer faces of the V - shaped wedge being at right angles to each other, the V - shaped wedge extending into the mouth of the press in a second direction opposite to the first direction and being aligned with the V - shaped slot in the female part, so that the V - shaped wedge may extend at least partly into the V - shaped slot when the press is closed; and a pair of side walls which, when the press is closed, are spaced apart from each other by substantially the width of the tubular member and which sidewalls extend over the sides of a V - shaped void defined between the female and male parts to, in use, confine the width of the tubular member to the width of the void substantially equal to the width of the V - shaped notch and the V - shaped wedge.

The method may use a male member which, at an apex of the V - shaped wedge, has a bullnosed section which extends across at least three quarter of the tip in the width direction, to define cut away distal corners of the male member.

At least one of the anti-vibration mounts may be a multi-directional wire rope mount, such as a Polycal wire rope mount, for example. Such mounts occupy minimal space within the container, thus reducing the 'dead space' between the container walls and the storage/payload space defined by the chassis. The overall dimensions of the container for a given storage/payload space can therefore be minimised. It will be appreciated that alternative anti-vibration mounts may also be used, such as a cylindrical wire rope mount or an elastomeric anti-vibration mount.

Non-limiting embodiments of the invention will now be described, by way of example only, with reference to the accompanying drawings in which:
Figure 1 is a perspective view of an electronic rack and mounting chassis;
Figure 2 is a perspective view of a front chassis member of the chassis shown in Figure 1;
Figure 3 is a cross-sectional view of the chassis taken through line III - III shown in Figure 1;
Figure 4 is a perspective view of an elongate chassis member of the chassis shown in Figure 1;
Figure 5 is a cross-sectional view of the chassis taken through line V - V shown in Figure 1;
Figure 6 is a perspective view of a container;
Figure 7 is an enlarges view of a side portion of the container of Figures 6, showing mounting of the chassis within a box;
Figure 8 is a cross-sectional view of a vertical side section of the chassis taken through line VIII-VIII shown in Figure 1;
Figure 9 is a perspective view of a tool of a press used to form the corner sections of the front and rear chassis members seen in Figures 2 and 3; and
Figure 10 is a similar perspective view to that of Figure 9, but showing an upper male part of the tool partly cut away.

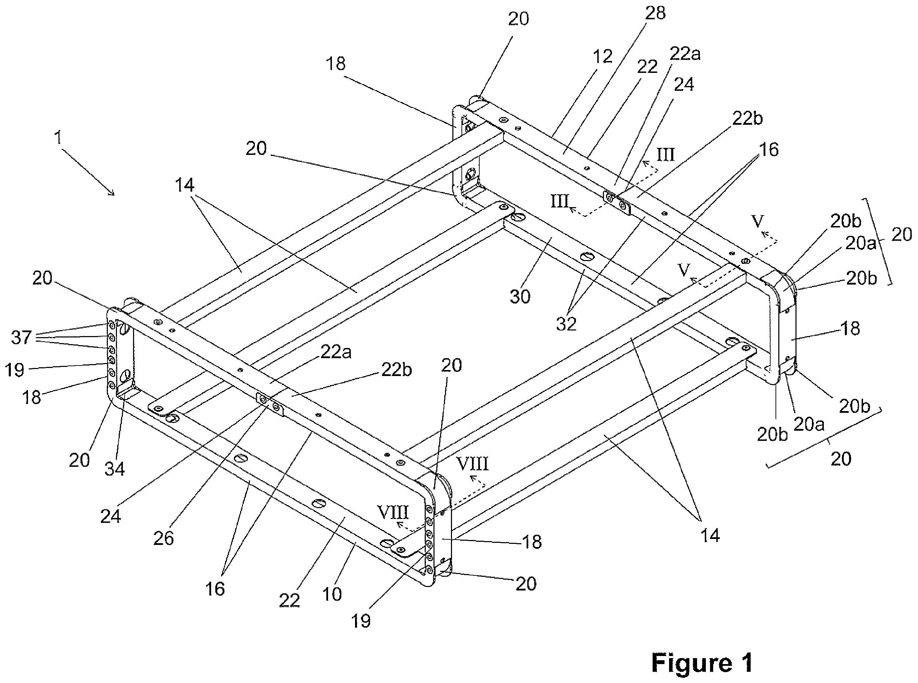

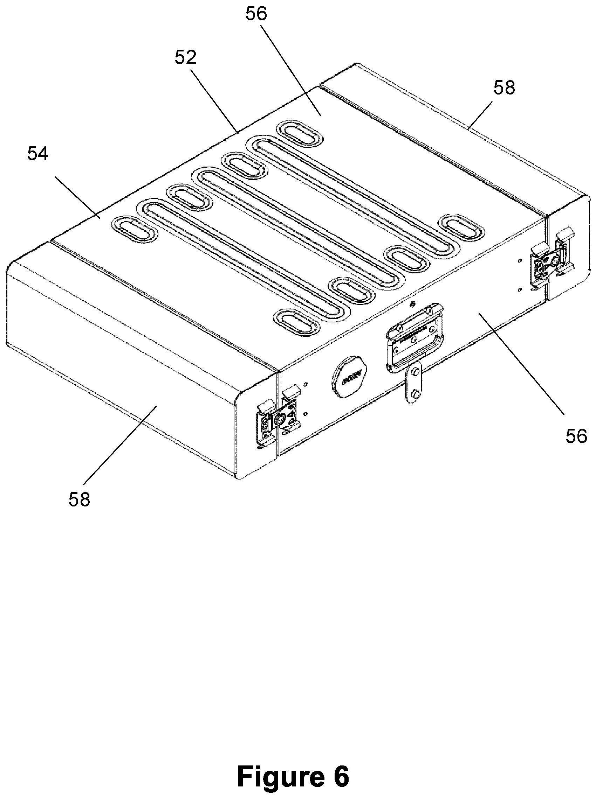

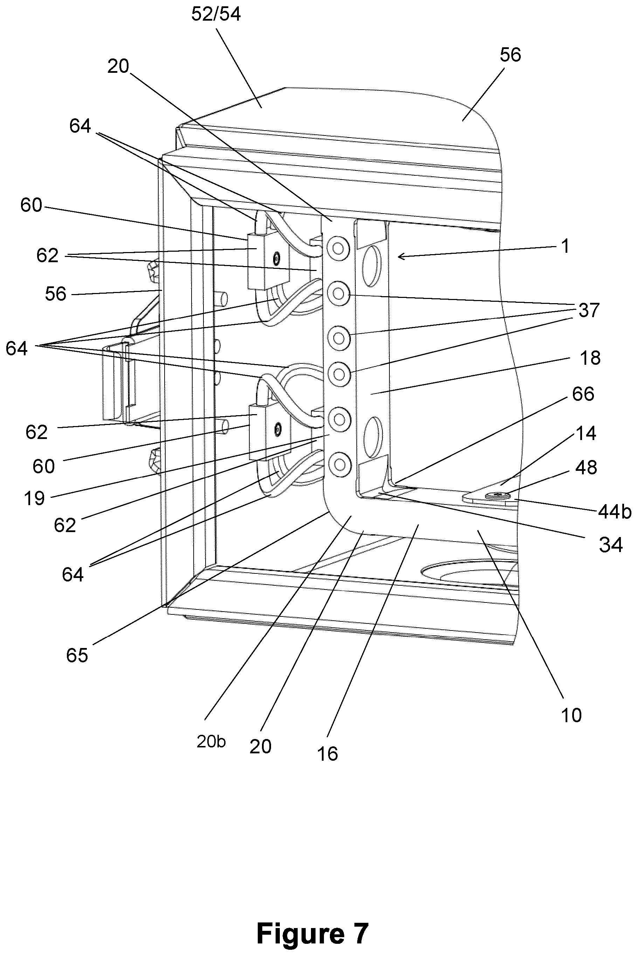

With reference to Figure 1, there is shown an electronic rack and mounting chassis 1 in accordance with the present invention. The electronic rack and mounting chassis 1 is provided for mounting within a suitably sized rigid outer container 52, shown in Figure 6, via anti-vibration mounts 60, one of which is seen in Figure 7. Suitable containers include rigid plastic or metal containers which substantially comprise a box with four walls, which extend in a front to back direction, the box comprising an opening at one or both of its ends, wherein the or each open end is closed using a removable or openable (e.g. hinged) lid. By removal or opening of the or each lid, electronic equipment mounted in the rack and mounting chassis may be accessed. Suitable plastic containers may be rotationally moulded. A range of chassis sizes will be available for a range of container sizes. The electronic rack and mounting chassis preferably complies to the universal 19-inch rack standard. The width of the chassis may remain constant whilst the height and/or the depth of the chassis is varied for different containers/equipment.

The chassis 1 comprises a front chassis member 10, a rear chassis member 12 and a plurality of elongate chassis members 14 extending in a front-to-rear direction and connecting the front and rear chassis members 10, 12. In the illustrated embodiment, the chassis 1 comprises four elongate chassis members 14 extending between and connecting the front chassis member 10 to the rear chassis member 12.

In the illustrated embodiment, each of the front chassis member 10, rear chassis member 12 and elongate chassis members 14 is formed from a hollow extruded tubular section having a substantially rectangular cross-sectional profile. Each hollow extruded tubular section comprises first and second horizontal walls and first and second vertical walls, defining a substantially rectangular internal cavity of the hollow section. The chassis members 10, 12, 14 may be extruded from high tensile strength aluminium, or from any alternative suitably strong/rigid material. The use of hollow tubular section extrusions for the chassis members provides significant rigidity to the chassis 1.

Each of the front and rear chassis members 10, 12 is in the form of a ring (looped structure) comprising two opposing horizontal sections 16, two opposing vertical side sections 18 and four corner sections 20. Each of the four corner sections 20 connects a respective one of the horizontal sections 16 to an adjacent one of the vertical side sections 18.

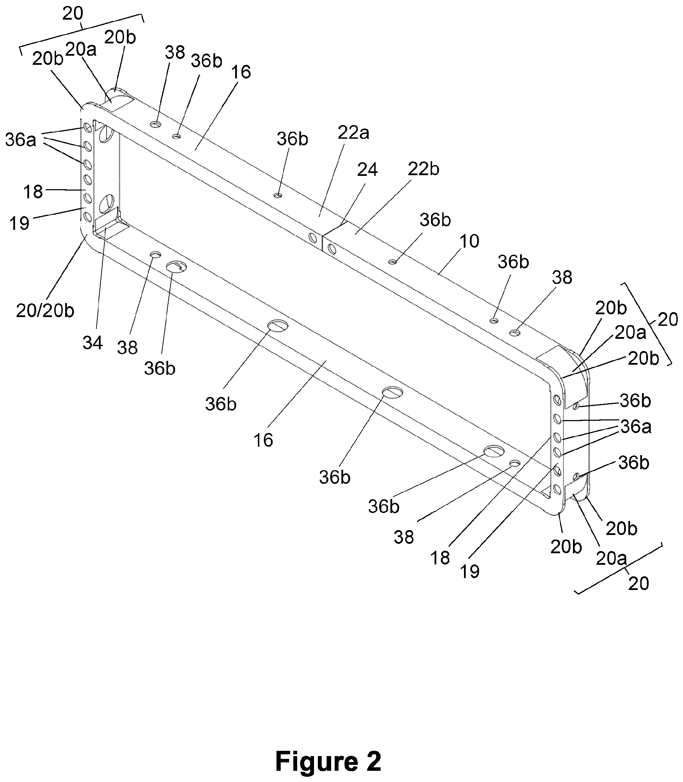

Each of the front and rear chassis members 10, 12 comprises a single, unitarily formed hollow extruded tubular section that is folded so as to form a folded element 22 defining the two horizontal sections 16, two vertical side sections 18 and four corner sections 20 of the ring. This is illustrated most clearly in Figure 2, which shows the front chassis member 10 of Figure 1, however it will be appreciated that the arrangement of the rear chassis member 12 is substantially the same.

A joint 24 connects a first end 22a of the folded element 22 to a second end 22b of the folded element 22 to form the looped structure, said joint 24 being formed in an upper horizontal section 16 in a location that is remote from each corner section 20 of the front/rear chassis member 10, 12.

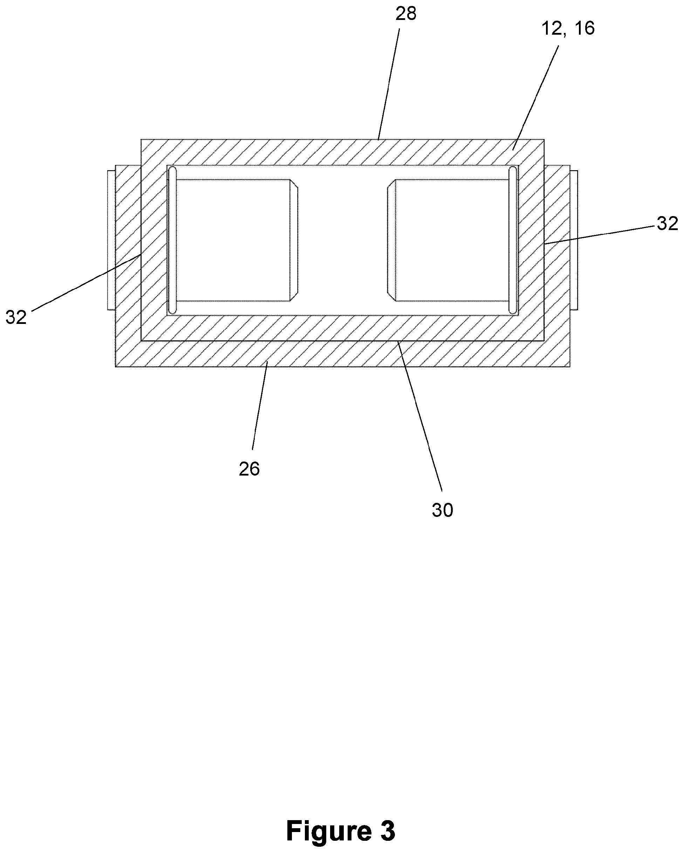

The joint 24 may be formed by any appropriate means for connecting the ends 22a, 22b of the folded element 22. In the illustrated embodiment, each of the front and rear chassis members 10, 12 comprises a U-shaped bracket 26 arranged to engage with external surfaces of the hollow extruded section at the two ends 22a, 22b to be connected, so as to bridge between the two ends 22a, 22b to connect the two ends 22a, 22b together and form the looped structure of the front/rear chassis member 10, 12. This is shown schematically in Figure 3, which is a cross section of a horizontal section 16 of the rear chassis member 12, through line III-III shown in Figure 1. Here, it can be seen that the hollow extruded section forming the rear chassis member 12 comprises a first horizontal wall 28 defining an external surface that faces outwardly from centre of the ring-like rear chassis member 12 (referred to hereafter as the outwardly-facing horizontal wall of the rear chassis member 12) and a second horizontal wall 30 defining an external surface that faces inwardly towards the centre of the ring-like rear chassis member 12 (referred to hereafter as the inwardly-facing horizontal wall of the rear chassis member 12). The outwardly-facing horizontal wall 28 extends around the outer periphery of the rear chassis member 12 and the inwardly-facing horizontal wall 30 extends around the inner periphery of the rear chassis member 12. The U-shaped bracket 26 engages with the inwardly-facing horizontal wall 30 and the two vertical walls 32 of the hollow section. This arrangement allows the two ends 22a, 22b of the folded element 22 to be connected, without the bracket 26 protruding beyond the outwardly-facing horizontal wall 28 of the rear chassis member 12. This allows the outwardly-facing horizontal wall 28 of the rear chassis member 12 to be positioned as close as possible to the internal walls of a container in which the chassis 1 is mounted, thus minimising the dimensions of the container whilst maximising the internal usable volume of the container that is defined by the chassis 1.

Whilst the arrangement of the joint 24 has been described above in relation to the rear chassis member 12, it will be appreciated that the front chassis member 10 has a corresponding arrangement.

Whilst in the illustrated embodiment, each of the front and rear chassis members 10, 12 comprises a single folded section, it will be appreciated that front and/or rear chassis members may comprise two or more folded elements that are joined together to form the ring, each folded element being folded to define one or more of the corner sections and at least a portion of the horizontal and vertical sections connected by the corner section. Accordingly, the front and/or rear chassis member may comprise a plurality of joints joining respective ends of the interconnecting folded sections to form the complete ring. For example, the front and/or rear chassis member may comprise two folded sections, each being folded to form a U-shape defining a vertical side section, a respective portion of each of the two opposing horizontal sections, and two corner sections connecting the vertical side section to the respective portions of the horizontal side sections. The two folded sections can then be joined by forming two joints connecting the respective ends of the portions of the horizontal sections. This can be envisaged with reference to the embodiment of Figure 1, in which a second joint could be formed in the second (lower) horizontal section that mirrors the joint formed in the first horizontal section. It will be appreciated that the front and/or rear chassis member may comprise up to four folded sections.

Referring to Figures 1 and 2, each corner section 20 of the front and rear chassis member 10, 12 comprises a curved outer face 20a (i.e. an outwardly facing surface of the front/rear chassis member 10, 12 in the corner section 20 thereof) and opposing wing portions 20b that are positioned on either side of the curved outer face 20a. The wing portions 20b extend outwardly beyond the curved outer face 20a. The opposing wing portions 20b increase the rigidity of the front/rear chassis member 10, 12 in the corner section 20, so as to prevent bending or flexing of the front/rear chassis member 10, 12 in use.

The folded elements 22 forming the front and rear chassis members 10, 12 are preferably crush folded, although other means of manufacturing folded elements with the desired structure are conceivable.

In the illustrated embodiment and as perhaps most clearly seen with reference to Figure 7, each corner section 20 comprises a recess 34 formed in that part of the inwardly facing horizontal wall 30 that forms an internal part of the corner section 20. In this regard, the internal part of the corner section 20 will be understood to refer to a face of the hollow section that faces inwardly towards the centre of the ring-like structure. The recess 34 is formed during the forming of the corner section 20 to provide somewhere for the metal forming the inwardly-facing horizontal wall 30 of the chassis member 10, 12 to be displaced to, in that region that becomes the internal part of the corner section 20, during folding to form the corner section 20. This permits the tubular member forming the corner section 20 to extend, folded, as a continuous length around the corner section 40, without the need for any cuts or welds, while the indent 34 also avoids excessive distortion of the opposing wing portions 20b and permits each outwardly facing edge of each wing portion 20b to be stretched during folding to form a relatively large radius curve 65, relative to the very small radius curve 66, formed on the compressed inwardly facing edge of the wing portion 20b. Thus, as seen most clearly in Figure 7, with the exception of the recessed portion 34, the inwardly-facing horizontal wall 30 of the rear chassis member forms a right angle and thus permits the corner section 20 to subtend a right-angled fold.

The right-angled corner section 20 is advantageous, for it permits the right-angled inwardly facing corner of the corner section 20 to receive the right-angled edge of electronic equipment to be supported by the chassis 1. This allows the internal usable volume of the container, that is defined by the internal dimensions of the chassis 1 to be maximised.

With continued reference to Figure 7, it will be noted that the width of the vertical walls 32 of the front chassis member 10 remains substantially constant as it transitions to form wing portion 20b, although in practice the wing portion may be up to fifteen percent narrower in the width direction in the folded portion of the corner section 20, relative to the width of the remaining portions of the vertical wall 32, due to distortion during the folding process. This substantial width of the vertical wall 32 in the region of the fold results in a particularly strong corner section that is very resistant to distortion.

The front and rear chassis members 10, 12 comprise a plurality of apertures 36 for receiving fasteners for the fastening of equipment to the chassis and/or for mounting the chassis 1 within a container.

In particular, in at least one of the front or rear chassis members 10, 12, each vertical side section 18 comprises a substantially planar front face 19 having a plurality of apertures 36a formed therein. These apertures 36a can be seen in Figure 2, in particular.

As shown in Figures 1, 7 and 8, a plurality of fasteners 37 are inserted into the apertures 36a for the mounting of equipment to the chassis 1, the equipment being secured against the planar front face 19 of the vertical side section 18. In the illustrated embodiment, each fastener 37 comprises a nut having a central through hole 37a, which is threaded to receive a suitable threaded fastener (e.g. a bolt or machine screw). In alternative arrangements the threaded hole may not extend through the nut. It may be a blind threaded hole.

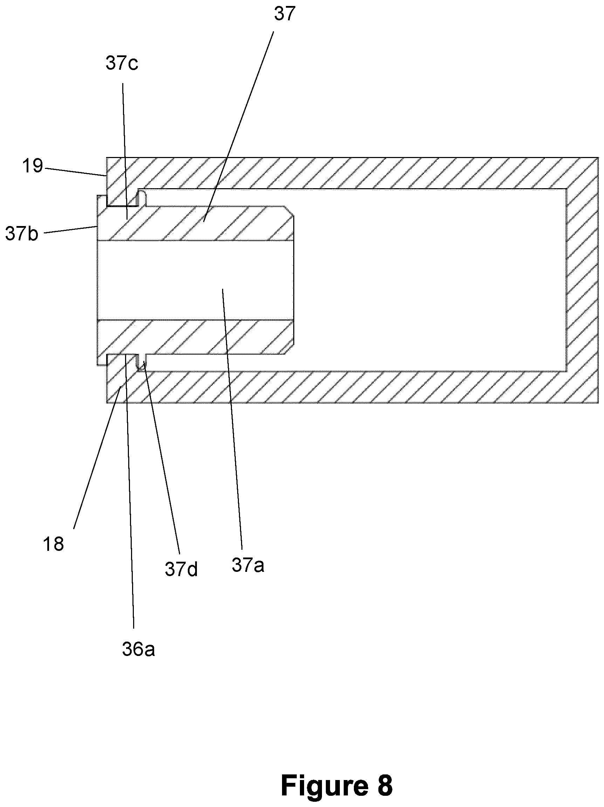

With reference to Figure 8, each fastener 37 comprises a head portion 37b having a dimension that is greater than the diameter of the aperture 36a that it is to be received by. A neck portion 37c has a smaller diameter than the aperture 36a, so that it may extend therethrough. A locking portion 37d is provided that has a dimension greater than the diameter of the aperture 36a. The head portion 37b engages with the planar front face 19 and the locking portion 37d engages with an opposing face of the vertical side section 18, so as to lock the fastener 37 within the aperture 36a. This arrangement allows the head portion 37b to be formed with a very low profile (that is, a small thickness in a direction perpendicular to the planar front face 19), allowing mounted equipment to sit substantially flat against the planar front face 19 of the vertical section 18.

The locking portion 37d may be formed by a crimping process that is carried out after insertion of the fastener 37 into the aperture 36a. In such arrangements, the fastener 37 may be formed with the head portion 37b having a dimension larger than the diameter of the aperture 36a, and a body portion having a dimension smaller than the diameter of the aperture 36a to allow for insertion of the body portion through the aperture 36a. With the head portion 37b braced against the substantially planar front face 19, the body portion is crimped to form the locking portion 37d and to define the neck portion 37c between the head portion 37b and the locking portion 37d. In this manner, the fastener 37 can be secured to a wall of a hollow member (e.g. a hollow extruded section), with minimal protrusion from the substantially planar front face 19 and without requiring access to the opposing face of said wall, with which the locking portion 27d engages. A fastener having a very low profile can therefore be achieved.

As shown in Figure 2, further apertures 36b may be provided in the front and/or rear chassis members 10, 12, in either the horizontal sections 16 or the vertical sections 18 thereof. Such apertures 36b may be used for the fastening of mounts, in particular anti-vibration mounts, for mounting the chassis 1 within a container.

Referring again to Figures 1 and 2, the front and rear chassis members 10, 12 further comprise a plurality of apertures 38 for receiving fasteners for the fastening the elongate chassis members 14 to the front and rear chassis members 10, 12, as will now be described.

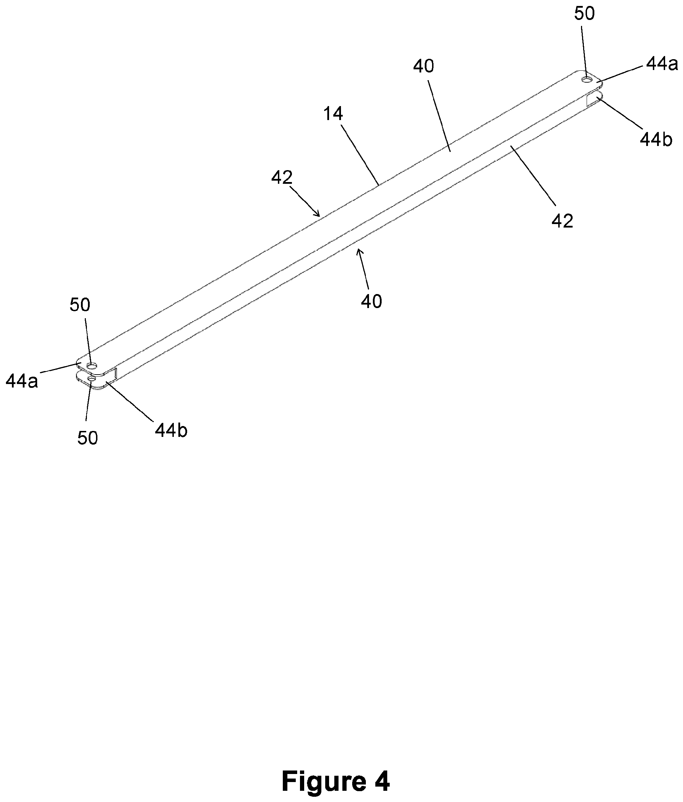

With reference to Figures 1, 4 and 5, in particular, each elongate chassis member 14 comprises a hollow extruded section having a substantially rectangular cross-sectional profile. The hollow extruded section defines two horizontal walls 40 and two vertical walls 42 extending between the horizontal walls 40, defining a substantially rectangular internal volume therebetween.

At opposing ends of the elongate members 14, the horizontal walls 40 extend further than the vertical walls 42 so as to define opposing tabs 44a, 44b, which are used for engaging with the front and rear chassis members 10, 12.

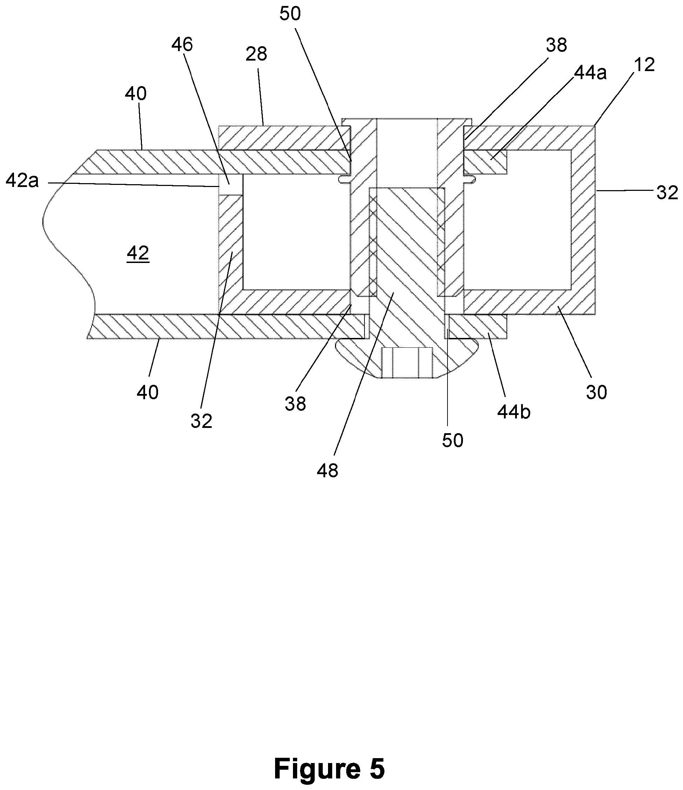

With reference to Figure 5, a first tab 44a is received within an aperture 46 formed in one vertical wall 32 of the front/rear chassis member 10, 12 and engages with an internal surface of the hollow extruded section forming the front/rear chassis member 10, 12. An edge 42a of the vertical wall 42 of the elongate chassis member 14 engages with the vertical wall 32 of the front/rear chassis member 10, 12 so as to limit the movement of the elongate chassis member 14 in a longitudinal direction thereof. At the same time, a second tab 44b engages with an external surface of the hollow extruded section forming the front/rear chassis member 10, 12, said external surface defining the inwardly-facing horizontal wall 30 of the front/rear chassis member 10, 12.

Fasteners 48 extend through apertures 50 formed in the tabs 44a, 44b and corresponding apertures 38 formed in the horizontal walls 28, 30 of the front/rear chassis members 10, 12, so as to fasten the elongate chassis member 14 to the front/rear chassis member 10, 12. By the introduction of fasteners 48, movement of the elongate chassis members 14 relative to the front/rear chassis members 10, 12 is prevented and a rigid secured chassis 1 is provided.

The above-described arrangement allows the elongate chassis members 14 to be connected to the front/rear chassis members 10, 12 without extending beyond the outwardly-facing wall 28 of the front/rear chassis member 10, 12, whilst also ensuring a secure connection and rigid chassis 1. This allows the outwardly-facing horizontal wall 28 of the front/rear chassis members 10, 12 to be positioned as close as possible to the internal walls of a container in which the chassis 1 is mounted, thus minimising the dimensions of the container whilst maximising the internal usable volume of the container that is defined by the chassis.

Referring now to Figure 6, there is shown a container 52 comprising a box 54 with four walls 56, which extend in a front to back direction, the box 54 comprising an opening at both of its ends, wherein the or each open end is closed using a removable lid 58. By removal of the or each lid 58, electronic equipment mounted within the container 52 may be accessed. It will be appreciated that each lid 58 may be fully removable, or may be partially removable (i.e. openable) so as to allow access to the opening for accessing electronic equipment mounted therein, for example in a hinged arrangement.

As shown in Figure 7, the container 52 comprises a chassis 1 as described above with reference to Figures 1 to 5. The chassis 1 is mounted within the container 52 by anti-vibration mounts 60 in the form of multi-directional wire rope mounts. Each mount 60 comprises a pair of body portions 62 connected by wire ropes 64. One body portion 62 is fastened to a wall 56 of the container box 54, and the other body portion 62 is fastened to a vertical section 18 of the front/rear chassis member 10, 12. Although not shown in Figure 7, it will be appreciated that the body portion 62 of the mount 60 may be fastened with an appropriate fastener accommodated within one of the apertures 36b located in a vertical section 18 of the front/rear chassis member 10, 12 (said apertures 36b being visible in Figure 2). Further mounts may be fastened to the horizontal sections 16 of the front/rear chassis members 10, 12 via the apertures 36b formed in the horizontal sections 18 thereof (also visible in Figure 2)

The use of wire rope mounts of this type require only a single fixing for fastening to each of the box wall 56 and chassis 1, allowing dimensions of the mount to be minimised, this also minimising 'dead space' within the container 52 between the chassis 1 and the internal walls 56 of the box 54. This allows the usable space within the container 52 defined by the dimensions of the chassis 1 to be maximised. The overall dimensions of the container 52, for a given payload space, can therefore be minimised.

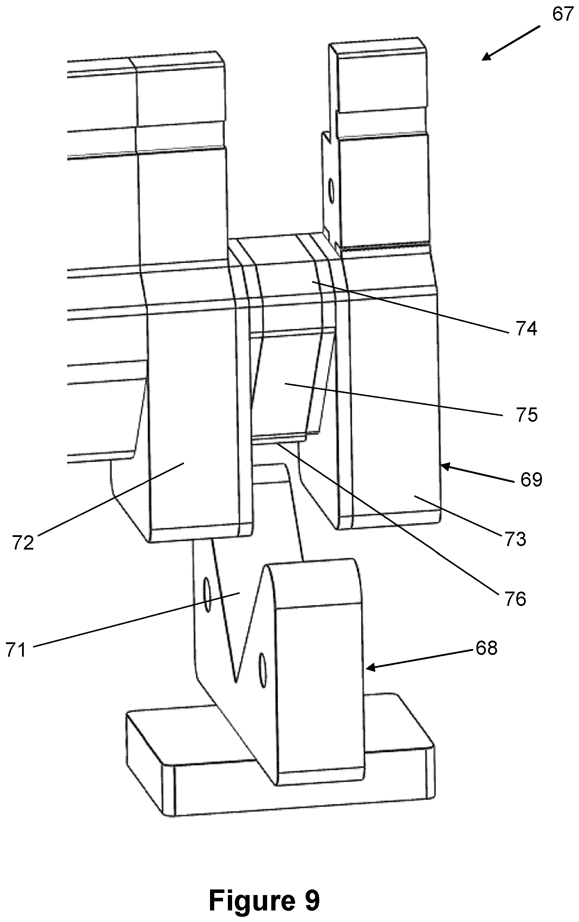

With reference to Figure 9, this shows a tool, indicated generally as 67, for mounting in a press and for folding a straight hollow tubular member to form the front and rear chassis members 10 and 11, previously described. The tool comprises a female part 68 and a male part 69, opposed to the female part with, the two parts arranged to be mounted in a press so that the male part 69 may, in the orientation shown in Figure 9, be pressed downwardly towards the female part 68. The female part comprises a steel block 70 which is equal in width to the width of the straight hollow tubular member (not shown in Figure 9) which is to be bent to form either a front chassis member 10 or a rear chassis member 11.

The steel block 70 defines a V - shaped notch 71 where the inner faces of the V - shaped notch are at right angles to each other.

Considering now to the male part 69 of the tool 67, this comprises a pair of side walls 72 and 73 spaced apart by a V - shaped wedge portion 74. The width of the V - shaped wedge 74 is the same as the width of the steel block 70 so that in use, when the male part 69 is brought together with the female part 68 the side walls 72 and 73 pass down the respective sides of the V - shaped notch 71 with very little clearance between the side walls 72 and 73 and the steel block 70.

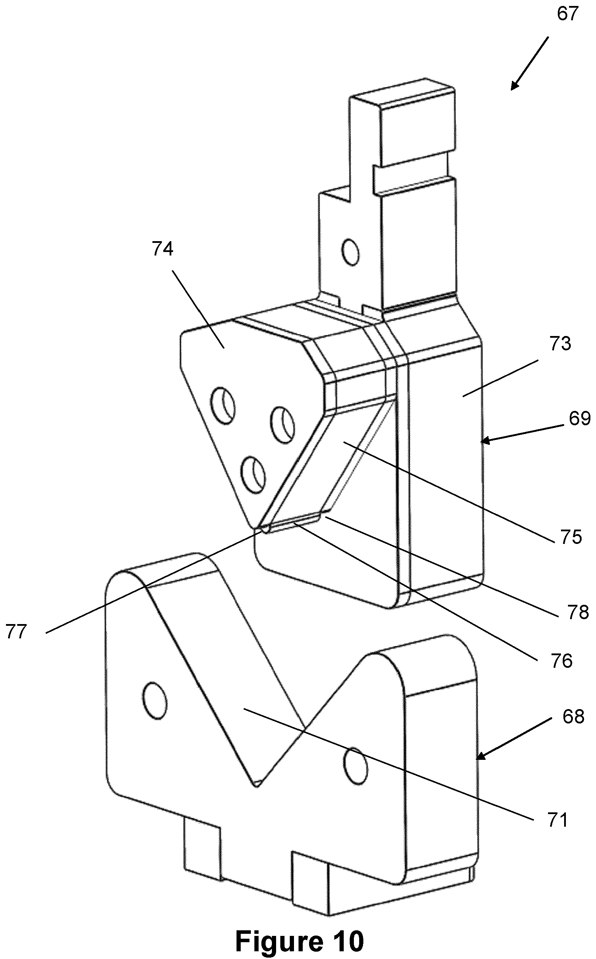

Referring now to Figure 10, this is a similar perspective view to that of Figure 9, but with the side wall 72 omitted to permit the V - shaped wedge 74 to be more clearly seen. The V - shaped wedge 74 has two outward faces 75, only one of which can be seen, and these are arranged at 90° relative to each other. At their apex, in the central portion of the V - shaped wedge 74, the V - shaped wedge 74 has a bullnosed section 76 extending across the central threequarters of the apex, leaving side portions into which the bullnose section does not extend. This thus leaves small recesses 77 and 78, to either side of the bullnose section.

With reference to Figure 9, in use a straight hollow tubular member of an appropriate length, typically a cut length of extruded aluminium, having a rectangular cross-section with a width substantially equal to the spacing between the side walls 72 and 73, is fed into the tool 67 from the front, as viewed in Figure 9, between the female and male parts 68 and 69 to an appropriate position and then the press is operated to bring the female part 68 and male part 69 together until the spacing between the faces of the V - shaped notch 71 and the faces 75 of the V - shaped wedge 74 are separated by a distance equal to the height of the tubular member, whereupon the tubular member will be folded to form a right angled corner section 20, as previously described. The process of closing the press forms the corner section 20 including forming indent 34, the curved outer face 20a of the corner section 20 and the opposing wing portions 20b positioned on either side of the curved outer face 20a, with the wing portions 20b extending outwardly beyond the curved outer face 20a.

After a first corner section 20 has been formed, the press is released returning the female and male parts 68 and 69 to the position shown in Figure 9, whereby the tubular member may be fed further into the tool 67 and the press operated to form one or more subsequent corner sections 20.

The invention has been described above with reference to specific embodiments, given by way of example only. It will be appreciated that different arrangements of the system are possible, which fall within the scope of the appended claims.

## Claims

1. An electronic rack and mounting chassis comprising:
a front chassis member;
a rear chassis member;
a plurality of elongate chassis members extending in a front-to-rear direction and connecting the front and rear chassis members,
wherein each of the front and rear chassis members comprises two opposing horizontal sections, two opposing vertical side sections and four corner sections, each of the four corner sections connecting a respective one of the horizontal sections to an adjacent one of the vertical side sections to form a looped structure,
wherein each of the front and rear chassis members comprises one or more folded elements, each folded element comprising a hollow tubular member having a substantially square or rectangular cross-sectional profile, folded to form one or more of the corner sections, with each corner section comprising a curved outer face and opposing wing portions positioned on either side of the curved outer face, the wing portions extending outwardly beyond the curved outer face, and
wherein each of the front and rear chassis members further comprises at least one joint at which respective ends of the one or more folded elements are connected to form the looped structure, the or each joint being formed in one of the vertical and horizontal sections so as to be remote from each corner section.

2. An electronic rack and mounting chassis as claimed in claim 1, wherein at least one of the front chassis member and the rear chassis member comprises a single, unitarily formed folded element that is folded so as to define the two horizontal sections, two vertical side sections and four corner sections, wherein a single joint connects a first end of the folded element to a second end of the folded element to form the looped structure, said joint being formed in one of the vertical and horizontal sections so as to be remote from each corner section.

3. An electronic rack and mounting chassis as claimed in claim 1 or 2, wherein each corner section comprises a recess formed in a wall of the hollow member that forms an internal part of the corner section.

4. An electronic rack and mounting chassis as claimed in any preceding claim, wherein each corner section comprises an inner face and wherein the opposing wing portions extending outwardly beyond the curved outer face have a radiused outer profile and wherein each wing portion defines a side edge of the inner face and wherein each side edge of the inner face of each corner section is substantially right angled.

5. An electronic rack and mounting chassis as claimed in any preceding claim, wherein the or each folded element is crush folded.

6. An electronic rack and mounting chassis as claimed in any preceding claim, wherein each elongate chassis member is connected to the front chassis member and the rear chassis member at a position remote from each corner section of the front and rear chassis members.

7. An electronic rack and mounting chassis as claimed in any preceding claim, wherein each of the front chassis member and the rear chassis member comprises an outwardly-facing wall extending around an outer periphery of the front or rear chassis member, an inwardly-facing wall extending around an inner periphery of the front or rear chassis member, and two opposing side walls extending between the outwardly-facing wall and the inwardly-facing wall

8. An electronic rack and mounting chassis as claimed in claim 7, wherein each elongate chassis member is connected to each of the front and rear chassis members without extending beyond the outwardly-facing wall thereof.

9. An electronic rack and mounting chassis as claimed in claim 8, wherein each elongate chassis member engages with the inwardly-facing wall and/or at least one of the side walls of each of the front and rear chassis members.

10. An electronic rack and mounting chassis as claimed in any one of claims 7 to 9, wherein each elongate chassis member comprises a tab arranged to be received within an aperture formed in one of the side walls of one of the front or rear chassis members, said tab engaging with an internal surface of the hollow member.

11. An electronic rack and mounting chassis as claimed in any one of claims 7 to 10, wherein each elongate chassis comprises a tab that engages with an external surface of the inwardly-facing wall of each of the front or rear chassis members.

12. A container comprising an electronic rack and mounting chassis as claimed in any one of claims 1 to 11.

13. A container as claimed in claim 12, wherein the container comprises a body which comprises a box with four walls, which extend in the front to back direction, the box comprising an opening at one or both of its ends, wherein the or each open end is closed using a removable or openable lid, and anti-vibration mounts are provided for mounting the electronic rack and mounting chassis within the container.

14. A method of forming a folded element of an electronic rack and mounting chassis as claimed in any of claims 1 to 11, the method comprising:
taking a straight hollow tubular member having a substantially square or rectangular cross-sectional profile having a width and a height;
placing the tubular member between two parts of a tool of a press and closing the press to fold the tubular member to form one of the corner sections, the action of closing the press forming the corner section, including forming the curved outer face of the corner section and the opposing wing portions positioned on either side of the curved outer face, which wing portions extend outwardly beyond the curved outer face, wherein the tool comprises:
a female part in the form of a block substantially equal in width to the width of the tubular member and having a V - shaped notch facing in a first direction into a mouth of the press, with inner faces of the V - shaped notch being at right angles to each other;
a male part, opposed to the female part, the male part in the form of a V - shaped wedge substantially equal in width to the width of the tubular member with the outer faces of the V - shaped wedge being at right angles to each other, the V - shaped wedge extending into the mouth of the press in a second direction opposite to the first direction and being aligned with the V - shaped slot in the female part, so that the V - shaped wedge may extend at least partly into the V - shaped slot when the press is closed; and
a pair of side walls which, when the press is closed, are spaced apart from each other by substantially the width of the tubular member and which sidewalls extend over the sides of a V - shaped void defined between the female and male parts to, in use, confine the width of the tubular member to the width of the void substantially equal to the width of the V - shaped notch and the V - shaped wedge.

15. A method as claimed in claim 14 wherein a distal tip of the male member, at an apex of the V - shaped wedge, has a bullnosed section which extends across at least three quarter of the tip in the width direction, to define cut away distal corners of the male member.
